# EUROPEAN PATENT SPECIFICATION

(11) **EP 2 795 682 B1**
(45) Date of publication and mention of the grant of the patent: **30.09.2015**
(21) Application number: 12864027.3
(22) Date of filing: 18.12.2012
(51) Int. Cl.: H01L 31/048

(54) **METHOD OF FORMING A PHOTOVOLTAIC CELL MODULE HAVING IMPROVED IMPACT RESISTANCE**
VERFAHREN ZUR HERSTELLUNG EINES PHOTOVOLTAIKZELLMODULS MIT VERBESSERTER SCHLAGFESTIGKEIT
PROCÉDÉ DE FABRICATION DE MODULE DE CELLULE PHOTOVOLTAÏQUE AYANT UNE RÉSISTANCE À L'IMPACT AMÉLIORÉE

(30) Priority: 19.12.2011 US 201161577319 P
(43) Date of publication of application: 29.10.2014
(73) Proprietor: Dow Corning Corporation, Midland, Michigan 48686-0994 (US)
(72) Inventor: KETOLA, Barry, Freeland, MI 48623 (US)
(74) Representative: Fyfe, Fiona Allison Watson
(86) International application number: PCT/US2012/070342
(87) International publication number: WO 2013/133884

(56) References cited:
- WO-A2-2010/141697
- US-A1- 2008 223 442
- US-A1- 2008 276 983
- US-A1- 2011 162 705

## Description

This invention was made with government support under NREL Subcontract No. ZAX-5-33628-02, Prime Contract No: DE-AC36-99GO10337 awarded by the Department of Energy. The government has certain rights in the invention.

This disclosure relates to a photovoltaic cell module and a process of forming the same using a silicone gel and an elastomer.

Document US 2008/0276983A discloses encapsulations for solar cells.

Photovoltaic (PV) cells are semiconductor devices that convert light into electricity and include substrates and superstrates that provide protection in many different environments. Heavy and expensive substrates and superstrates that include glass and polymers provide maximum protection to resist impact, heat and cold, and moisture.

### SUMMARY OF THE DISCLOSURE

The instant disclosure provides a method of forming a photovoltaic cell module with improved impact resistance. The module includes a first layer, a silicone elastomer disposed on the first layer and a crystalline photovoltaic cell disposed on the silicone elastomer. The module also includes a second elastomer disposed opposite the silicone elastomer and on the crystalline photovoltaic cell. The module also has an impact resistance of greater than 1,200 grams.

The method includes the step of contacting a hydrosilylation-curable silicone composition and/or a cured silicone gel thereof with an organosilicon compound comprising at least two silicon-bonded hydrogen atoms per molecule to cure via a hydrosilylation reaction and form the silicone elastomer disposed on the first layer. The method also includes the step of disposing the second elastomer opposite the silicone elastomer and on the crystalline photovoltaic cell. The hydrosilylation-curable silicone composition includes an organopolysiloxane having an average of at least two silicon-bonded alkenyl groups per molecule, an organohydrogensiloxane having an average of at least two silicon-bonded hydrogen atoms per molecule, and a hydrosilylation catalyst, and that has a molar ratio of SiH:alkenyl of less than about 1.2:1. The method forms the photovoltaic cell module having the aforementioned impact resistance.

### BRIEF DESCRIPTION OF THE SEVERAL VIEWS OF THE DRAWINGS

Other advantages and aspects of the disclosure are described in the following detailed description and accompanying drawings wherein:
Figure 1 is a side view of one embodiment of a photovoltaic cell module;
Figure 2 is a side view of another embodiment of a photovoltaic cell module;
Figure 3 is a side view of yet another embodiment of a photovoltaic cell module; and
Figure 4 is a side view of still another embodiment of a photovoltaic cell module.

### DETAILED DESCRIPTION OF THE DISCLOSURE

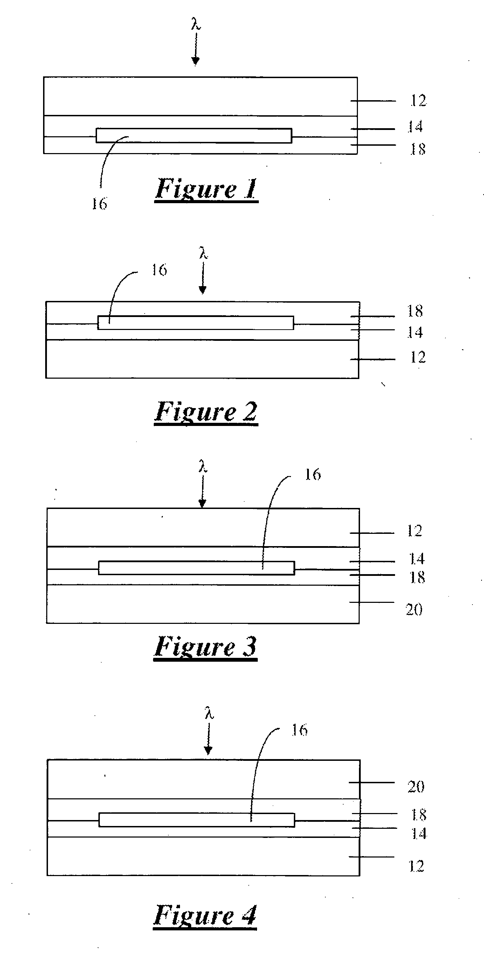

Many photovoltaic cell modules (modules) are susceptible to cracking, physical deformation, and destruction when impacted. In addition, air is often trapped between liquid silicone compositions and various surfaces of the modules. The present disclosure provides an improved module 10 generally shown in Figures 1-4 and a method of forming the module 10.

The module 10 has improved impact resistance, as measured in break strength. Typically, the impact resistance of the module 10 is at least 1,000, 1,100, 1,200, 1,300, 1,400, 1,500, 1,600, 1,700, 1,800, 1,900, 2,000, 2,100, 2,200, 2,300, 2,400, 2,500, 2,600, or 2,700, grams. Typically, the impact resistance is determine using a TA-XT2 Texture Analyzer commercially available from Stable Micro Systems and a ¼ inch ball, as described in detail below. In various other embodiments, the module 10 has an impact resistance of from 1,700 to 2,800, from 1,800 to 2,700, from 1,900 to 2,600, from 2,000 to 2,500, from 2,100 to 2,400, or from 2,200 to 2,300, grams.

The module 10 includes a first layer 12, a silicone elastomer 14 disposed on the first layer 12 and a crystalline photovoltaic cell 16 disposed on the silicone elastomer 14. The module 10 also includes a second elastomer 18 disposed opposite the silicone elastomer 14 and on the crystalline photovoltaic cell 16.

The terminology "disposed on" may describe the silicone elastomer 14 disposed on and in direct contact with the first layer 12 (as shown in Figures 1-4) or spaced apart from the first layer 12 and not in direct contact with the first layer 12. The crystalline photovoltaic cell 16 may be disposed on and in direct contact with the silicone elastomer 14 (as shown in Figures 1-4) or spaced apart from the silicone elastomer 14 and not in direct contact with the silicone elastomer 14. The second elastomer 18 may be disposed on and in direct contact with the crystalline photovoltaic cell 16 (as shown in Figures 1-4) or spaced apart from the crystalline photovoltaic cell 16 and not in direct contact with the crystalline photovoltaic cell 16. In one embodiment, the silicone elastomer 14 is disposed on and in direct contact with the first layer 12, the crystalline photovoltaic cell 16 is disposed on and in direct contact with the silicone elastomer 14 and still disposed on, but spaced apart from the first layer 12, and the second elastomer 18 is disposed on and in direct contact with the silicone elastomer 14 and still disposed on, but spaced apart from the first layer 12. In another embodiment, the module 10 includes a second layer 20 disposed on the second elastomer 18, as shown in Figures 3 and 4. The second layer 20 may be disposed on and in direct contact with the second elastomer 18 (as shown in Figures 3 and 4) or spaced apart from the second elastomer 18 and not in direct contact with the second elastomer 18. The first layer 12, silicone elastomer 14, crystalline photovoltaic cell 16, second elastomer 18, and second layer 20 are each described in greater detail below. Each of the first layer 12, the silicone elastomer 14, the crystalline photovoltaic cell 16, the second elastomer 18, and the second layer 20 may be described as disposed on any of the others whether they are in direct contact therewith or whether they are spaced apart from any of the others and not in direct contact therewith. Typically, the crystalline photovoltaic cell 16 is sandwiched between the silicone elastomer 14 and the second elastomer 18.

The first layer 12 and/or second layer 20 may each be a substrate and/or a superstrate. In a module 10 that includes the first layer 12 and the second layer 20, one of the two layers 12, 20 is typically a substrate and the other of the two layers 12, 20 is typically a superstrate. The substrate and/or superstrate are not limited and may include any material known in the art.

Typically, the substrate provides protection to a rear surface of the module 10 and the superstrate provides protection to a front surface of the module 10. The substrate and/or superstrate may each be soft and flexible or rigid and stiff. Alternatively, the substrate and/or superstrate may include rigid and stiff segments while simultaneously including soft and flexible segments. The substrate and/or superstrate may be transparent to light, may be opaque, or may not transmit light. The substrate and/or superstrate may include glass, stainless steel, metal foils, polyimides, ethylene-vinyl acetate copolymers, and/or organic fluoropolymers such as ethylene tetrafluoroethylene (ETFE), Tedlar^{®} (polyvinylfluoride), polyester/Tedlar^{®}, Tedlar^{®}/polyester/Tedlar^{®}, polyethylene terephthalate (PET) alone or coated with silicon and oxygen based materials (SiOₓ), and combinations thereof. In one embodiment, the substrate and/or superstrate is selected from the group of polyvinylfluoride and polyethylene. The substrate and/or superstrate may alternatively be a PET/SiOₓ-PET/Al substrate, wherein x is a number having a value of from 1 to 4. Still further, the substrate and/or superstrate may include silicone, may consist essentially of silicone and not include, or include less than 1 wt %, organic monomers or organic polymers, or may consist of silicone. The optional silicone chemistry of the substrate and/or superstrate is not limited and may include any type known in the art. The substrate and/or superstrate is not limited to the aforementioned compounds.

The substrate and/or superstrate may be load bearing or non-load bearing and may be included in any portion of the module 10. Typically, the substrate is load bearing and the superstrate is not load bearing. When module 10 is oriented towards a light source (e.g. the sun) for a photovoltaic operation, the substrate is typically a bottom and outermost layer of the module 10. Bottom layers are typically positioned behind the crystalline photovoltaic cells 16 and serve as mechanical support. The superstrate is typically a top and outermost layer of the module 10 and typically is oriented towards the light source. If both a substrate and superstrate are utilized, the substrate and superstrate each typically act as outermost layers and sandwich all other components of the module 10 therebetween.

The module 10 may be free of a "backsheet" and/or "front glass." The terminology "backsheet" typically describes a substrate, as described above. In one embodiment, the backsheet is metal foils, polyimides, ethylene-vinyl acetate copolymers, and/or organic fluoropolymers such as ethylene tetrafluoroethylene (ETFE), Tedlar® (polyvinylfluoride), polyester/Tedlar®, Tedlar®/polyester/Tedlar®, polyethylene terephthalate (PET) alone or coated with silicon and oxygen based materials (SiOx), and combinations thereof. The "backsheet" may alternatively be the PET/SiOₓ-PET/Al substrate. However, the module 10 may be free of the "backsheet" and still include one or more compounds or components described above as a substrate. The module 10 may still include a substrate and be free of a "backsheet." The terminology "front glass" typically describes glass or compound used as a superstrate that allows light to pass through. The module 10 may be free of the "front glass" and still include one or more compounds or components described above as a superstrate. The module 10 may still include a superstrate and be free of "front glass."

The silicone elastomer 14 is typically the cured reaction product of (1) a silicone gel and an organosilicon compound, (2) a hydrosilylation-curable silicone composition and the organosilicon compound, or (3) a combination of the silicone gel and the hydrosilylation-curable silicone composition and the organosilicon compound. The silicone gel/hydrosilylation-curable silicone composition and the organosilicon compound typically cure via a hydrosilylation reaction. In embodiment (2), the hydrosilylation-curable silicone composition and the organosilicon compound may react in a wet-on-wet system wherein each is a liquid at the start of the reaction. Conversely, the silicone gel is not typically considered a liquid in the same way as the hydrosilylation-curable silicone composition.

The silicone gel is not limited and may be any known in the art. Typically, silicone gels have a rotational viscosity less than 10,000, 5,000, or 1,000 cps measured at 25°C, typically according to ASTM D1084 and/or ASTM D 4287. In one embodiment, the silicone gel has a depth of penetration of from 1.1 to 100 nm and a tack value of less than -0.6 g·sec, measured at 25°C or at room temperature. The terminology "depth of penetration" may also be referred to as "penetration" or "penetration value." In various embodiments, the silicone gel has a depth of penetration of from 1.3 to 100 mm and more typically of from 2 to 55 mm. As temperature rises, the depth of,penetration values may also rise. The silicone gel may have a depth of penetration of from 1.1 to 100 mm, of from 1.3 to 100 mm, or of from 2 to 55 mm, as determined at room temperature or at any other temperature. Typically, depth of penetration is determined at room temperature.

The depth of penetration is determined by first calculating hardness and then calculating depth of penetration. Thus, the silicone gel typically has a hardness in grams (g) of Force of from 5 to 500, more typically of from 5 to 400, and most typically of from 10 to 300. More specifically, hardness is determined using a TA-XT2 Texture Analyzer commercially available from Stable Micro Systems using a 0.5 inch (1.27 cm) diameter steel probe. Test samples of the silicone gel having a mass of 12 g are heated at 100°C for 10 minutes and are analyzed for hardness using the following testing parameters, as known in the art: 2 mm/sec pre-test and post-test speed; 1 mm/s test speed; 4 mm target distance; 60 second hold; and a 5 g force trigger value. The maximum grams force is measured at 4 mm distance into the silicone gel.

Depth of penetration measurements are typically calculated using the hardness (grams of force) obtained using the TA-XT2 Texture Analyzer and the following equation: Depth of penetration (mm x 10) = 5,350/grams force. This relationship is determined using a universal penetrometer, commercially available from Precision Scientific of Chicago, Il, and by measuring hardness with the texture analyzer of the silicone gel. There typically are seventy nine sample measurements taken for the silicone gel. The 5,350 constant is determined by multiplying the depth of penetration by the grams of force from the texture analyzer for each of the seventy nine samples and then averaging the results.

The silicone gel may also have a tack value of less than -0.6 g.sec. In various embodiments, the silicone gel has a tack value of from -0.7 to -300 g.sec and more typically of from -1 to -100 g.sec. In one embodiment, the silicone gel has a tack value of about -27 g.sec. As temperature rises, the tack value may decrease. The silicone gel may have a tack value of less than -0.6 g.sec., of from -0.7 to -300 g.sec., or of from -1 to -100 g.sec., as determined at room temperature or at any other temperature. Typically, tack value is determined at room temperature.

The tack value is determined using the TA-XT2 Texture Analyzer using a 0.5 inch (1.27 cm) diameter steel probe. The probe is inserted into the silicone gel to a depth of 4 mm and then withdrawn at a rate of 2 mm/sec. The tack value is calculated as a total area (Force-Time) during withdrawal of the probe from the silicone gel. The tack value is expressed in gram.sec. wherein the time is measured as a time difference between a time when the force is equal to zero and a time when the probe separates from the silicone gel. Depth of penetration and tack values may not substantially change with varying thicknesses of the silicone gel. However, methods of determining the depth of penetration and the tack values may be modified depending on the thickness of the silicone gel. Examples of suitable gels for use as the silicone gel are described in U.S. Pat. Nos. 5,145,933, 4,340,709, and 6,020,409. The hydrosilylation-curable composition and/or the silicone gel also typically has an elastic modulus (G' at cure) of from 7 x 102 to 6 x 105, dynes/cm².

The silicone gel is typically formed by curing the hydrosilylation-curable silicone composition first introduced above. The silicone gel may be completely cured or partially cured, e.g. as evaluated based on tack value and/or an amount of unreacted components. The hydrosilylation-curable silicone composition typically includes an organopolysiloxane having an average of at least two silicon-bonded alkenyl groups per molecule, an organohydrogensiloxane having an average of at least two silicon-bonded hydrogen atoms per molecule, and a hydrosilylation catalyst, and typically has a molar ratio of SiH:alkenyl (e.g. vinyl or substituted vinyl) of less than about 1.2:1, less than about 1.1:1, or about 1:1. The silicone gel of this disclosure may be as described in one or both of U.S. Pat. App. Pub. No. 20110061724 and U.S. Pat. App. Ser. No. 13/126,603.

The organosilicon compound includes at least two silicon-bonded hydrogen atoms per molecule and alternatively at least three silicon-bonded hydrogen atoms per molecule. The organosilicon compound may be as described in U.S. Pat. App. Pub. No. 20100086760.

The organosilicon compound may be an organohydrogensilane or an organohydrogensiloxane. The organohydrogensilane can be a monosilane, disilane, trisilane, or polysilane. Similarly, the organohydrogensiloxane can be a disiloxane, trisiloxane, or polysiloxane. The structure of the organosilicon compound can be linear, branched, cyclic, or resinous. Cyclosilanes and cyclosiloxanes typically have from 3 to 12 silicon atoms, from 3 to 10 silicon atoms, from 4 to 8 silicon atoms, or from 3 to 4 silicon atoms. In acyclic polysilanes and polysiloxanes, the silicon-bonded hydrogen atoms can be located at terminal, pendant, or at both terminal and pendant positions.

Examples of organohydrogensilanes are diphenylsilane, 2-chloroethylsilane, bis[(p-dimethylsilyl)phenyl]ether, 1,4-dimethyldisilylethane, 1,3,5-tris(dimethylsilyl)benzene, 1,3,5-trimethyl-1,3,5-trisilane, poly(methylsilylene)phenylene, and poly(methylsilylene)methylene.

The organohydrogensilane can also have the formula HR¹₂Si-R³-SiR¹₂H, wherein each R¹ and R³ are independently as described and exemplified below. Examples of organohydrogensiloxanes are 1,1,3,3-tetramethyldisiloxane, 1,1,3,3-tetraphenyldisiloxane, phenyltris(dimethylsiloxy) silane, and 1,3,5-trimethylcyclotrisiloxane.

The organohydrogensilane can also have the formula HR¹₂Si-R³-SiR¹₂H, wherein each R¹ is independently C₁ to C₁₀ hydrocarbyl or halogen-substituted hydrocarbyl, both free of aliphatic unsaturation, and each R³ is independently a hydrocarbylene group free of aliphatic unsaturation having a formula selected from: 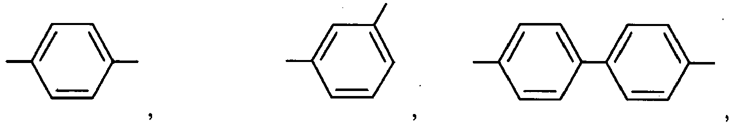 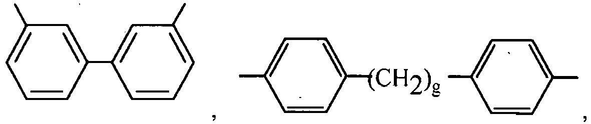 and 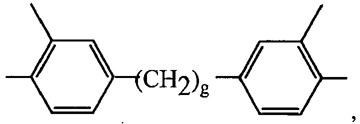 wherein g is from 1 to 6 and each R¹ is independently as described above.

Examples of organohydrogensilanes having the formula HR¹₂Si-R³-SiR¹₂H, wherein R¹ and R³ are as described and exemplified above, are silanes having the following formulae: 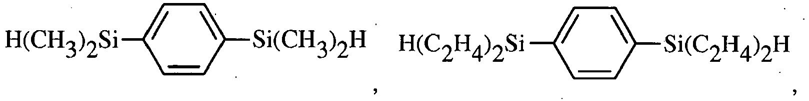 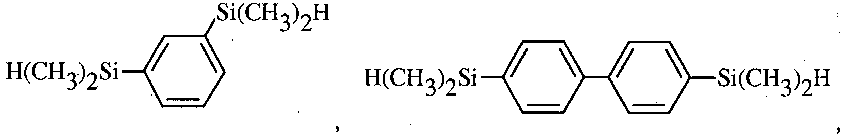 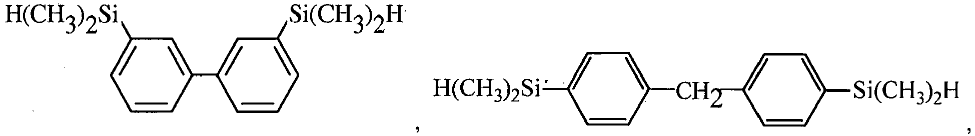 and

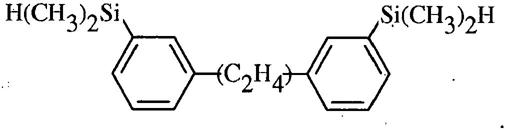

Examples of organohydrogensiloxanes are 1,1,3,3-tetramethyldisiloxane, 1,1,3,3-tetraphenyldisiloxane, phenyltris(dimethylsiloxy)silane, 1,3,5-trimethylcyclotrisiloxane, a trimethylsiloxy-terminated poly(methylhydrogensiloxane), a trimethylsiloxy-terminated poly(dimethylsiloxane/methylhydrogensiloxane), a dimethylhydrogen siloxy-terminated poly(methylhydrogensiloxane), and a resin consisting essentially of HMe₂SiO_{1/2} units, Me₃SiO_{1/2} units, and SiO_{4/2} units, wherein Me is methyl.

The organohydrogensiloxane can also be an organohydrogenpolysiloxane resin having the formula (R¹R⁴₂SiO_{1/2})_{w}(R⁴₂SiO_{2/2})ₓ(R¹SiO_{3/2})_{y}(SiO_{4/2})_{z}, wherein R⁴ is R¹ or an organosilylalkyl group having at least one silicon-bonded hydrogen atom.

The subscripts w, x, y, and z are mole fractions. The subscript w typically has a value of from 0 to 0.8, alternatively from 0.02 to 0.75, alternatively from 0.05 to 0.3; the subscript x typically has a value of from 0 to 0.6, alternatively from 0 to 0.45, alternatively from 0 to 0.25; the subscript y typically has a value of from 0 to 0.99, alternatively from 0.25 to 0.8, alternatively from 0.5 to 0.8; the subscript z typically has a value of from 0 to 0.35, alternatively from 0 to 0.25, alternatively from 0 to 0.15. Also, the sum y+z is typically from 0.2 to 0.99, alternatively from 0.5 to 0.95, alternatively from 0.65 to 0.9. Further, the sum w+x is typically from 0.01 to 0.80, alternatively from 0.05 to 0.5, alternatively from 0.1 to 0.35. In various embodiments, w is from 0 to 0.8, x is from 0 to 0.6, y is from 0 to 0.99, z is from 0 to 0.35, w+x+y+z=1, y+z is from 0.2 to 0.99, and w+x is from 0.01 to 0.8, provided at least 50 mol% of the groups R⁴ are organosilylalkyl.

Typically, at least 50 mol%, alternatively at least 65 mol%, alternatively at least 80 mol% of the groups R⁴ in the organohydrogenpolysiloxane resin are organosilylalkyl groups having at least one silicon-bonded hydrogen atom.

The hydrocarbyl and halogen-substituted hydrocarbyl groups represented by R¹ are as described and exemplified above. Examples of organosilylalkyl groups represented by R⁴ are groups having the following formulae:

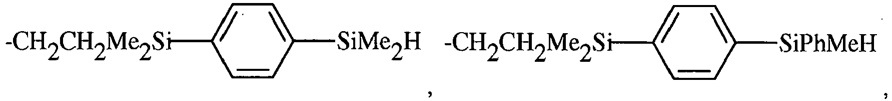

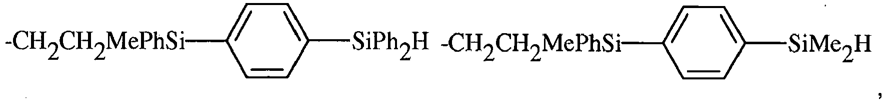

-CH₂CH₂SiMe₂H, -CH₂CH₂SiMe₂CₙH₂ₙSiMe₂H, -CH₂CH₂SiMe₂CₙH₂ₙSiMePhH,

-CH₂CH₂SiMePhH, -CH₂CH₂SiPh₂H, -CH₂CH₂SiMePhCₙH₂ₙSiPh₂H,

-CH₂CH₂SiMePhCₙH₂ₙSiMe₂H, -CH₂CH₂SiMePhOSiMePhH, and

-CH₂CH₂SiMePhOSiPh(OSiMePhH)₂,

where Me is methyl, Ph is phenyl, and the subscript n has an integer value of from 2 to 10.

The organohydrogenpolysiloxane resin typically has a number-average molecular weight (Mₙ) of from 500 to 50,000 g/mol, alternatively from 500 to 10,000 g/mol, alternatively 1,000 to 3,000, g/mol, where the molecular weight is determined by gel permeation chromatography employing a low angle laser light scattering detector, or a refractive index detector and silicone resin (MQ) standards. The organohydrogenpolysiloxane resin typically includes less than 10% (w/w), alternatively less than 5% (w/w), alternatively less than 2% (w/w), of silicon-bonded hydroxy groups, as determined by ²⁹Si NMR.

In other embodiments, the organohydrogenpolysiloxane resin includes R¹SiO_{3/2} units (i.e., T units) and/or SiO_{4/2} units (i.e., Q units) in combination with R¹R⁴₂SiO_{1/2} units (i.e., M units) and/or R⁴₂SiO_{2/2} units (i.e., D units), where R¹ and R⁴ are as described and exemplified above. For example, the organohydrogenpolysiloxane resin can be a DT resin, an MT resin, an MDT resin, a DTQ resin, and MTQ resin, and MDTQ resin, a DQ resin, an MQ resin, a DTQ resin, an MTQ resin, or an MDQ resin.

Examples of organohydrogenpolysiloxane resins are resins having the following formulae:

((HMe₂SiC₆H₄SiMe₂CH₂CH₂)₂MeSiO_{1/2})_{0.12}(PhSiO_{3/2})_{0.88},

((HMe₂SiC₆H₄SiMe₂CH₂CH₂)₂MeSiO_{1/2})_{0.17}(PhSiO_{3/2})_{0.83},

((HMe₂SiC₆H₄SiMe₂CH₂CH₂)₂MeSiO_{1/2})_{0.17}(MeSiO_{3/2})_{0.17}(PhSiO_{3/2})_{0.66},

((HMe₂SiC₆H₄SiMe₂CH₂CH₂)₂MeSiO_{1/2})_{0.15}(PhSiO_{3/2})_{0.75}(SiO_{4/2})_{0.10},

and

((HMe₂SiC₆H₄SiMe₂CH₂CH₂)₂MeSiO_{1/2})_{0.08}((HMe₂SiC₆H₄SiMe₂CH₂CH₂)Me₂SiO_{1/2})_{0.06} (PhSiO_{3/2})_{0.86}, where Me is methyl, Ph is phenyl, C₆H₄ denotes a para-phenylene group, and

the numerical subscripts outside the parenthesis denote mole fractions. Also, in the preceding formulae, the sequence of units is unspecified.

The organosilicon compound can be a single organosilicon compound or a mixture comprising two or more different organosilicon compounds, each as described above. For example, the organosilicon compound can be a single organohydrogensilane, a mixture of two different organohydrogensilanes, a single organohydrogensiloxane, a mixture of two different organohydrogensiloxanes, or a mixture of an organohydrogensilane and an organohydrogensiloxane. In particular, the organosilicon compound can be a mixture comprising at least 0.5% (w/w), alternatively at least 50% (w/w), alternatively at least 75% (w/w), based on the total weight of the organosilicon compound, of the organohydrogenpolysiloxane resin, and an organohydrogensilane and/or organohydrogensiloxane, the latter different from the organohydrogenpolysiloxane resin.

The concentration of the organosilicon compound is typically sufficient to further cure (cross-link) the silicone gel and form the silicone elastomer. The exact amount of the organosilicon compound depends on the desired extent of cure, which generally increases as the ratio of the number of moles of silicon-bonded hydrogen atoms to the number of moles of alkenyl groups increases. The concentration of the organosilicon compound is typically sufficient to provide from 0.4 to 2 moles of silicon-bonded hydrogen atoms, alternatively from 0.8 to 1.5 moles of silicon-bonded hydrogen atoms, alternatively from 0.9 to 1.1 moles of silicon-bonded hydrogen atoms, per mole of alkenyl groups.

Methods of preparing organosilicon compounds containing silicon-bonded hydrogen atoms are well known in the art. For example, organohydrogensilanes can be prepared by reaction of Grignard reagents with alkyl or aryl halides. In particular, organohydrogensilanes having the formula HR¹₂Si-R³-SiR¹₂H can be prepared by treating an aryl dihalide having the formula R³X₂ with magnesium in ether to produce the corresponding Grignard reagent and then treating the Grignard reagent with a chlorosilane having the formula HR¹₂SiCl, where each R¹ and R³ are independently as described and exemplified above. Methods of preparing organohydrogensiloxanes, such as the hydrolysis and condensation of organohalosilanes, are also well known in the art.

In addition, the organohydrogenpolysiloxane resin can be prepared by reacting (a) a silicone resin having the formula (R¹R²₂SiO_{1/2})_{w}(R²₂SiO_{2/2})ₓ (R¹SiO_{3/2})_{y}(SiO_{4/2})_{z} with (b) an organosilicon compound having an average of from two to four silicon-bonded hydrogen atoms per molecule and a molecular weight less than 1,000 g/mol, in the presence of (c) a hydrosilylation catalyst and, optionally, (d) an organic solvent, wherein each R¹ is independently as described above, R² is R¹ or alkenyl, w is from 0 to 0.8, x is from 0 to 0.6, y is from 0 to 0.99, z is from 0 to 0.35, w+x+y+z=1, y+z is from 0.2 to 0.99, and w+x is from 0.01 to 0.8, provided the (a) silicone resin has an average of at least two silicon-bonded alkenyl groups per molecule, and the mole ratio of silicon-bonded hydrogen atoms to alkenyl groups is from 1.5 to 5.

The organosilicon compound is typically at least one organosilicon compound having an average of from two to four silicon-bonded hydrogen atoms per molecule. Alternatively, the organosilicon compound may have an average of from two to three silicon-bonded hydrogen atoms per molecule. The organosilicon compound typically has a molecular weight less than 1,000, alternatively less than 750, alternatively less than 500, g/mol. Silicon-bonded organic groups in the organosilicon compound are selected from hydrocarbyl and halogen-substituted hydrocarbyl groups, both free of aliphatic unsaturation, which are as described and exemplified above for R¹.

In one embodiment, the hydrosilylation-curable silicone composition includes greater than 55, alternatively greater than 60, parts by weight of a diorganopolysiloxane, based on 100 parts by weight of the hydrosilylation-curable silicone composition. In another embodiment, the organosilicon compound is utilized in an amount of from 5 to 25, from 5 to 20, or from 8 to 22.5 parts by weight based on 100 parts by weight of the hydrosilylation-curable silicone composition.

The crystalline photovoltaic cell 16 is not limited and may be any known in the art. The crystalline photovoltaic cell 16 typically has a thickness of from 50 to 250, more typically of from 100 to 225, and most typically of from 175 to 225, micrometers. The crystalline photovoltaic cell 16 also typically has a length and width of from 100 x 100 cm to 200 x 200 cm. In one embodiment, the crystalline photovoltaic cell 16 has a length and width of 125 cm each. In another embodiment, the crystalline photovoltaic cell 16 has a length and width of 156 cm each. The crystalline photovoltaic cell 16, and the instant disclosure, are not limited to these dimensions.

The crystalline photovoltaic cell 16 may include large-area, single-crystal, single layer p-n junction diodes. These crystalline photovoltaic cells 16 are typically made using a diffusion process with silicon wafers. Alternatively, the crystalline photovoltaic cell 16 may include thin epitaxial deposits of (silicon) semiconductors on lattice-matched wafers. In this embodiment, the epitaxial photovoltaics may be classified as either space or terrestrial and typically have AM0 efficiencies of from 7 to 40%. Further, the crystalline photovoltaic cell 16 may include quantum well devices such as quantum dots, quantum ropes, and carbon nanotubes. These types of crystalline photovoltaic cells 16 can have up to a 45% AMO production efficiency. Still further, the crystalline photovoltaic cell 16 may include mixtures of polymers and nano particles that form a single multispectrum layer.

The crystalline photovoltaic cell 16 may include monocrystalline silicon, polycrystalline silicon, microcrystalline silicon, nanocrystalline silica, cadmium telluride, copper indium/gallium selenide/sulfide, gallium arsenide, polyphenylene vinylene, copper phthalocyanine, carbon fullerenes, and combinations thereof in ingots, ribbons, thin films, and/or wafers. The crystalline photovoltaic cell 16 may also include light absorbing dyes such as ruthenium organometallic dyes and typically includes monocrystalline and polycrystalline silicon.

The second elastomer 18 is also not limited and may be a silicone or a non-silicone. Suitable non-limiting examples of non-silicones include organic elastomers and plastics. In one embodiment, the second elastomer 18 is a second silicone elastomer and may be the same or different than any of the aforementioned silicones. The second elastomer 18 may be an inner or outermost layer of the module 18 and may be load bearing or non-loading bearing. The second elastomer 18 may have one or more of the properties of the substrate and/or superstrate described above. The second elastomer 18 may be transparent, non-transparent, opaque, etc. and is not limited relative to light transmission. In another embodiment, the second elastomer 18 is an organic plastic, e.g. an organic plastic backsheet.

The crystalline photovoltaic cell 16 may sandwich the silicone elastomer 14 between the first layer 12 and the crystalline photovoltaic cell 16. The second elastomer 18 may also sandwich the crystalline photovoltaic cell 16 between the silicone elastomer 14 and the second elastomer 18. Alternatively, the crystalline photovoltaic cell 16 may be encapsulated by the silicone elastomer 14 and the second elastomer 18. The crystalline photovoltaic cell 16 may be completely or partially encapsulated.

In one embodiment, the hydrosilylation-curable silicone composition is disposed on and in direct contact with the first layer 12 and/or the crystalline photovoltaic cell 16, the crystalline photovoltaic cell 16 sandwiches the silicone elastomer 14 between the first layer 12 and the crystalline photovoltaic cell 16, and the second elastomer 18 sandwiches the crystalline photovoltaic cell 16 between the silicone elastomer 14 and the second elastomer 18. In another embodiment, the first layer 12 is substrate.

In still another embodiment, e.g. as set forth in Figure 3, the first layer 12 is a superstrate, the hydrosilylation-curable silicone composition is disposed on and in direct contact with the first layer 12 and/or the crystalline photovoltaic cell 16, the crystalline photovoltaic cell 16 sandwiches the silicone elastomer 14 between the first layer 12 and the crystalline photovoltaic cell 16, the second elastomer 18 sandwiches the crystalline photovoltaic cell 16 between the silicone elastomer 14 and the second elastomer 18, and the second layer 20 is disposed on and in direct contact with the second elastomer 18.

In an even further embodiment, the first layer 12 is a substrate, the hydrosilylation-curable silicone composition is disposed on and in direct contact with the first layer 12 and/or the crystalline photovoltaic cell 16, the crystalline photovoltaic cell 16 sandwiches the silicone elastomer 14 between the first layer 12 and the crystalline photovoltaic cell 16, the second elastomer 18 sandwiches the crystalline photovoltaic cell 16 between the silicone elastomer 14 and the second elastomer 18, and the second layer 20 is disposed on and in direct contact with the second elastomer 18.

The hydrosilylation-curable silicone composition typically has a low SiH/Alkenyl (e.g. SiH: vinyl) ratio (typically less than 1.2:1, 1:1, or about 1 and cures to form a tacky undercross-linked product (i.e., the gel). The SiH of the organosilicon compound typically penetrates the gel and reacts with the silicone gel (i.e., cross-links the silicone gel) to form an elastomer at the interface. The organosilicon compound (an SiH crosslinker) provides a localized SiH/Alkenyl ratio greater than or equal to 1.

This disclosure also includes the method of forming the module 10. The method includes the step of contacting the hydrosilylation-curable silicone composition and/or a cured silicone gel thereof with the organosilicon compound to cure via a hydrosilylation reaction and form the silicone elastomer disposed on the first layer. The method also includes the step of disposing the second elastomer opposite the silicone elastomer and on the crystalline photovoltaic cell. The method may include the steps of providing the hydrosilylation-curable silicone composition and/or curing the hydrosilylation-curable silicone composition to form the silicone gel. The method may also include the step of disposing the silicone gel on the first layer 12 and/or the crystalline photovoltaic cell 16. In one embodiment, the step of providing is disposing the hydrosilylation-curable silicone composition on the first layer 12 and/or the crystalline photovoltaic cell 16. In this embodiment, when the composition cures to form the silicone gel, the step of curing will accomplish the step of disposing the silicone gel on the first layer 12 and/or the crystalline photovoltaic cell 16. Alternatively, the hydrosilylation-curable composition may be provided off-site and/or away from the first layer 12 and/or the crystalline photovoltaic cell 16. In this embodiment, the composition may be cured to form the silicone gel off-site and/or away from the first layer 12 and/or the crystalline photovoltaic cell 16. Said differently, the silicone gel may be formed independently from the method or may be formed as a step of the method. Subsequently, the silicone gel may then be disposed on the first layer 12 and/or the crystalline photovoltaic cell 16 by any means known in the art.

The method may also include the step of disposing the organosilicon compound on the first layer 12 and/or the crystalline photovoltaic cell 16 and/or the step of contacting the silicone gel and the organosilicon compound to cure via a hydrosilylation reaction and form the silicone elastomer 14. The method also includes the step of disposing the second elastomer 20 opposite the silicone elastomer and on the crystalline photovoltaic cell.

The step of disposing the hydrosilylation-curable silicone composition and/or the step of disposing the silicone gel may be further independently defined as disposing on and in direct contact with the first layer 12 and/or the crystalline photovoltaic cell 16. Alternatively, the step of disposing the hydrosilylation-curable silicone composition and/or the step of disposing the silicone gel may be further independently defined as disposing on, but spaced apart from and not in direct contact with, the first layer 12 and/or the crystalline photovoltaic cell 16. Similarly, the step of disposing the organosilicon compound on the first layer 12 and/or the crystalline photovoltaic cell 16 may be disposing the organosilicon compound on and in direct contact with the first layer 12 and/or the crystalline photovoltaic cell 16. Alternatively, the organosilicon compound may be disposed on, but spaced apart from and not in direct contact with, the first layer 12 and/or the crystalline photovoltaic cell 16. In one embodiment, the organosilicon compound is disposed on and in direct contact with the first layer 12 and the hydrosilylation-curable composition and/or silicone gel is disposed on and in direct contact with the organosilicon compound and still disposed on, but spaced apart from and not in direct contact with, the first layer 12. In another embodiment, the hydrosilylation-curable composition and/or silicone gel is disposed on and in direct contact with the first layer 12 and the organosilicon compound is disposed on and in direct contact with the hydrosilylation-curable composition and/or silicone gel and still disposed on, but spaced apart from and not in direct contact with, the first layer 12.

The steps of disposing the hydrosilylation-curable silicone composition, the silicone gel, and/or the organosilicon compound are not limited and each may be further independently defined as disposing using a cloth, plastic, fabric, foam, or metal applicator, disposing using a spray gun, nozzle, or curtain coater, disposing using a laminator, press, and/or mechanical system, and/or disposing via placing, pouring, dipping, brushing, spraying, coating, etc. In one embodiment, one or more disposing steps are disposing using a cloth applicator. In another embodiment, one or more disposing steps are using a foam applicator, e.g. saturating the foam applicator and contacting the first layer 12 and/or crystalline photovoltaic cell 16 with the foam. The order of the aforementioned steps is not limited such that the steps may occur in any order.

The step of curing is also not limited such that the hydrosilylation-curable composition may be fully or partially cured to form the silicone gel so long as the silicone gel is as described above. For example, heat may be applied such as with a laminator or press to effect curing. The step of contacting the silicone gel and the organosilicone compound is also not limited and may be pressing, laminating, or compressing using rollers, weights, mechanical systems, etc. The step of disposing the second elastomer opposite the silicone elastomer is also not limited and may be independently any one or more of the aforementioned methods described above relative to the steps of disposing the hydrosilylation-curable silicone composition and/or disposing the organosilicon compound.

A series of photovoltaic cells modules of this disclosure (Modules 1-6) were formed according to the method of this disclosure. A comparative photovoltaic cell module (Comparative Module 1) was also formed but is not representative of this disclosure because it was not formed using any organosilicon compound. Said differently, the Comparative Module 1 does not include any of the organosilicon compound used to form the Modules 1-6 of this invention.

More specifically, a hydrosilylation-curable silicone composition was disposed on glass sections (i.e., "first layers") having dimensions of 6 by 6 inches, at a thickness of about 0.015 inches, and cured to form a silicone gel of this disclosure. The hydrosilylation-curable silicone composition included dimethyl siloxane, hydrogen-terminated; dimethyl, methylhydrogen siloxane; dimethyl siloxane, dimethylvinyl-terminated; polydimethylsiloxane; and a platinum hydrosilylation catalyst and has a molar ratio of SiH:alkenyl (e.g. SiH:vinyl) of about less than about 1. The silicone gel was a vinyldimethylsilyl end-blocked polydimethylsiloxane having a viscosity of 450 mPa.s at 25° C and including 0.46 weight percent Si-Vinyl bonds. The silicone gel had a Shore 00 Durometer hardness of about 0, a hardness (grams of force) of about 11.5, a depth of penetration (mm) of about 46.5, an Elastic Modulus G' at Cure (dynes/cm² of about 7.75 x 10³, and a tack value of about -27.4 (g.sec) as Area F-T 3:4, with a Time 1 (sec) of about 67, a Time 2 (sec) of about 73, and a Time 2-1 (sec) of about 6.

Varying amounts of polydimethylsiloxane (PDMS) fluid (as an inert diluent) were combined with varying amounts of a poly(methylhydrogensiloxane) fluid (i.e., an organosilicon compound including at least two silicon-bonded hydrogen atoms per molecule) to form the following Mixtures:
Mixture 1: 100 wt % poly(methylhydrogensiloxane); 0 wt % PDMS fluid.
Mixture 2: 75 wt % poly(methylhydrogensiloxane); 25wt % PDMS fluid.
Mixture 3: 50 wt % poly(methylhydrogensiloxane); 50 wt % PDMS fluid.
Mixture 4: 25 wt % poly(methylhydrogensiloxane); 75 wt % PDMS fluid.
Mixture 5: 18 wt % poly(methylhydrogensiloxane); 82 wt % PDMS fluid.
Mixture 6: 12.5 wt % poly(methylhydrogensiloxane); 87.5 wt % PDMS fluid.
Mixture 7: 0 wt % poly(methylhydrogensiloxane); 100 wt % PDMS fluid.

After formation, each of the Mixtures was individually disposed on different 6 by 6 inch Aleo multi-crystalline photovoltaic cells, at a thickness of about 0.010 inches, using a cloth soaked in a respective Mixture. One photovoltaic cell was then contacted (i.e., compressed) with one aforementioned glass section including the silicone gel such that the silicone gel contacted the poly(methylhydrogensiloxane) fluid, reacted, and cured via a hydrosilylation reaction to form a silicone elastomer and a corresponding Module of this disclosure. Mixtures 1-6 were used to form Modules 1-6, respectively. Mixture 7 was used to form Comparative Module 1 since Mixture 7 did not include any of the poly(methylhydrogensiloxane) (i.e., the organosilicon compound). Accordingly, Mixture 7 and Comparative Module 1 are not representative of this disclosure.

Additional Modules (Modules 7 and 8) were also formed using Mixtures 4 and 5, respectively. Modules 7 and 8 were formed using the identical procedure described above except that the Mixtures were applied to the 6 by 6 inch Aleo multi-crystalline photovoltaic cells, at a thickness of about 0.010 inches, by soaking a foam layer in the respective Mixture and contact the photovoltaic cells with the foam to transfer the Mixture from the foam to the cell.

After formation, each Module was visually evaluated to determine whether any air bubbles were observable between the glass and the photovoltaic cells. The visual evaluations were made initially (i.e., at time zero after formation) and after one hour (i.e., at time of formation + 1 hr). Bubbles are undesirable and typically result from reaction of excess Si-H with moisture thereby forming hydrogen gas bubbles. If hydrosilylation reactions occur too quickly, the silicones formed therefrom can harden too quickly such that any bubbles formed may not be able to be effectively evacuated from the silicones.

In addition, each Module was evaluated after one hour using a TA-XT2 Texture Analyzer commercially available from Stable Micro Systems and a ¼ inch ball to determine break strength, i.e., impact resistance. More specifically, the settings and parameters of the TA-XT2 Texture Analyzer were as follows:

| | |
|---|---|
| Trigger Type: Auto | Test Speed: 0.1 mm/sec |
| Trigger Force: 10g | Post Test Speed: 1 mm/sec |
| Points Per Second: 500 | Applied Force: 2,000.0 g |
| Probe: TA47R | T.A. Variable No. 6: 0.0g |
| T.A. Variable No. 1: Tension | Return Distance: 2.00 mm |
| Pre-Test Speed: 0.5 mm/sec | T.A. Variable No. 8: 0.0% |

The break strength was calculated as an average of six measurements made at different spots on the backside of the cell. The results of the aforementioned evaluations to determine break strength are set forth in Table 1 immediately below.

**TABLE 1**

| | **Mixture/Technique Used** | **Break Strength (g)** | **Percentage Increase Over Comparative** | **Air Bubbles (Initial)** | **Air Bubbles 1 Hour)** |
|---|---|---|---|---|---|
| **Module 1** | Mixture 1 (Cloth Applicator) | ∼ 2690 | ∼ +119% | > 20 | > 20 |
| **Module 2** | Mixture 2 (Cloth Applicator) | ∼ 2600 | ∼ + 111% | ∼1-20 | > 20 |
| **Module 3** | Mixture 3 (Cloth Applicator) | ∼ 2590 | ∼ + 110% | ∼1-20 | ∼1-20 |
| **Module 4** | Mixture 4 (Cloth Applicator) | ∼ 2740 | ∼ + 122% | ∼1-20 | ∼1-20 |
| **Module 5** | Mixture 5 (Cloth Applicator) | ∼ 2400 | ∼ + 96% | ∼1-20 | ∼1-20 |
| **Module 6** | Mixture 6 (Cloth Applicator) | ∼ 1880 | ∼ + 53% | ∼1-20 | ∼1-20 |
| **Module 7** | Mixture 4 (Foam Applicator) | ∼ 1740 | ∼ + 41% | ∼1-20 | ∼1-20 |
| **Module 8** | Mixture 5 (Foam Applicator) | ∼ 2500 | ∼ +104% | No Air Bubbles Visible | No Air Bubbles Visible |
| **Comparative Module 1** | Mixture 7 (Cloth Applicator) | ∼ 1230 | --- | No Air Bubbles Visible | No Air Bubbles Visible |

In Table 1 above, "∼" is indicative of approximation and "---" in indicative of non-relevancy. The data set forth above clearly shows that Modules 1-8 of this disclosure outperform the Comparative Module 1 relative to Break Strength (i.e., impact resistance). The only result effective difference in the Modules 1-6 and the Comparative Module 1 is the amount of the organosilicon compound used. In other words, each of the Modules 1-8 is formed using an amount of the organosilicon compound. Comparative Module 1 is formed without using any of the organosilicon compound. All other components and conditions are constant.

The data also shows that a quantity of air bubbles can be reduced using less of the poly(methylhydrogensiloxane), i.e., the organosilicon compound. Bubbles are undesirable and typically result from reaction of excess Si-H with moisture thereby forming hydrogen gas bubbles. Reducing the amount (concentration) of the poly(methylhydrogensiloxane) reduces the amount of SiH groups available for reaction which slows hydrosilylation reactions and reduces formation of hydrogen gas.

In the aforementioned examples, the hydrosilylation-curable silicone composition cures to form the silicone gel. The organosilicon compound tends to penetrate the silicone gel and react with the silicone gel to form an elastomer due to a localized increase in the molar ratio of SiH:alkenyl of greater than 1:1. The silicone elastomer tends to increase the impact resistance of the photovoltaic cell module because it tends to support the cell and allow for minimization or elimination of superstrates and/or substrates which decreases costs, production complexities, and production times.

One or more of the values described above may vary by ± 5%, ± 10%, ± 15%, ± 20%, ± 25%, etc. so long as the variance remains within the scope of the disclosure. Unexpected results may be obtained from each member of a Markush group independent from all other members. Each member may be relied upon individually and or in combination and provides adequate support for specific embodiments within the scope of the appended claims. The subject matter of all combinations of independent and dependent claims, both singly and multiply dependent, is herein expressly contemplated. The disclosure is illustrative including words of description rather than of limitation.

## Claims

1. A method of forming a photovoltaic cell module with improved impact resistance and comprising a first layer, a silicone elastomer disposed on the first layer, a crystalline photovoltaic cell disposed on the silicone elastomer, and a second elastomer disposed opposite the silicone elastomer and on the crystalline photovoltaic cell, said method comprising the steps of:
A. contacting a hydrosilylation-curable silicone composition and/or a cured silicone gel thereof with an organosilicon compound comprising at least two silicon-bonded hydrogen atoms per molecule to cure via a hydrosilylation reaction and form the silicone elastomer disposed on the first layer; and
B. disposing the second elastomer opposite the silicone elastomer and on the crystalline photovoltaic cell,
wherein the hydrosilylation-curable silicone composition comprises an organopolysiloxane having an average of at least two silicon-bonded alkenyl groups per molecule, an organohydrogensiloxane having an average of at least two silicon-bonded hydrogen atoms per molecule, and a hydrosilylation catalyst, and has a molar ratio of SiH:alkenyl of less than about 1.2:1, and
wherein the photovoltaic cell module has an impact resistance of greater than about 1,200 grams.

2. The method of claim 1 further comprising the step of disposing the hydrosilylation-curable silicone composition on the first layer and/or the crystalline photovoltaic cell and optionally curing the hydrosilylation-curable silicone composition to form the cured silicone gel.

3. The method of claim 1 or 2 further comprising the step of disposing the organosilicon compound on the first layer and/or the crystalline photovoltaic cell.

4. The method of any one of claims 1 to 3 wherein the cured silicone gel has a depth of penetration of from 1.1 to 100 nm and a tack value of less than -0.6 g·see measured at 25°C.

5. The method of any one of claims 1, 2, or 4 wherein the hydrosilylation-curable silicone composition is disposed on and in direct contact with the first layer and/or the crystalline photovoltaic cell, wherein the crystalline photovoltaic cell sandwiches the silicone elastomer between the first layer and the crystalline photovoltaic cell, and wherein the second elastomer sandwiches the crystalline photovoltaic cell between the silicone elastomer and the second elastomer.

6. The method of any one of claims 1, 2, or 4 wherein the first layer is a superstrate, wherein the hydrosilylation-curable silicone composition is disposed on and in direct contact with the first layer and/or the crystalline photovoltaic cell, wherein the crystalline photovoltaic cell sandwiches the silicone elastomer between the first layer and the crystalline photovoltaic cell, wherein the second elastomer sandwiches the crystalline photovoltaic cell between the silicone elastomer and the second elastomer, and wherein the method further comprises the step of disposing a second layer on and in direct contact with the second elastomer.

7. The method of any one of claims 1, 2, or 4 wherein the first layer is a substrate, wherein the hydrosilylation-curable silicone composition is disposed on and in direct contact with the first layer and/or the crystalline photovoltaic cell, wherein the crystalline photovoltaic cell sandwiches the silicone elastomer between the first layer and the crystalline photovoltaic cell, wherein the second elastomer sandwiches the crystalline photovoltaic cell between the silicone elastomer and the second elastomer, and wherein the method further comprises the step of disposing a second layer on and in direct contact with the second elastomer.

8. The method of any one of claims 1 to 7 wherein the crystalline photovoltaic cell sandwiches the silicone elastomer between the first layer and the crystalline photovoltaic cell.

9. The method of any one of claims 1 to 8 wherein the second elastomer sandwiches the crystalline photovoltaic cell between the silicone elastomer and the second elastomer and the second elastomer is optionally a second silicone elastomer.

10. A photovoltaic cell module having improved impact resistance and comprising:
A. a first layer;
B. a silicone elastomer disposed on said first layer and comprising the hydrosilylation reaction product of;
(1) hydrosilylation-curable silicone composition and/or a cured silicone gel thereof, and
(2) an organosilicon compound comprising at least two silicon-bonded hydrogen atoms per molecule;
C. a crystalline photovoltaic cell disposed on said silicone elastomer; and
D. a second elastomer disposed opposite said silicone elastomer and on said crystalline photovoltaic cell,
wherein said hydrosilylation curable silicone composition comprises (a) an organopolysiloxane having an average of at least two silicon-bonded alkenyl groups per molecule, (b) an organohydrogensiloxane having an average of at least two silicon-bonded hydrogen atoms per molecule, and (c) a hydrosilylation catalyst, and having a molar ratio of SiH:alkenyl of less than about 1, and
wherein said photovoltaic cell module has an impact resistance of greater than about1,200 grams.

11. The module of claim 10 wherein said cured silicone gel has a depth of penetration of from 1.1 to 100 nm and a tack value of less than -0.6 g·sec measured at 25°C

12. The module of claim 10 or 11 wherein said silicone elastomer is disposed on and in direct contact with said first layer and said crystalline photovoltaic cell, wherein said crystalline photovoltaic cell sandwiches said silicone elastomer between said first layer and said crystalline photovoltaic cell, and wherein said second elastomer sandwiches said crystalline photovoltaic cell between said silicone elastomer and said second elastomer.

13. The module of any one of claims 10 to 12 wherein said organosilicon compound is an organohydrogensilane.

14. The module of any one of claims 10 to 12 wherein said organosilicon compound is an organohydrogensiloxane.

15. The module of any one of claims 10 to 12 that is free of a backsheet and/or free of front glass.

## Patentansprüche

1. Verfahren zum Bilden eines Photovoltaikzellenmoduls mit verbesserter Stoßfestigkeit und umfassend eine erste Schicht, ein auf der ersten Schicht angeordnetes Silikonelastomer, eine auf dem Silikonelastomer angeordnete kristalline Photovoltaikzelle, und ein zweites Elastomer, das gegenüber dem Silikonelastomer und auf der kristallinen Photovoltaikzelle angeordnet ist, wobei das Verfahren die folgenden Schritte umfasst:
A. das Inkontaktbringen einer durch Hydrosilylierung aushärtbaren Silikonzusammensetzung und/oder eines ausgehärteten Silikongels davon mit einer siliciumhaltigen organischen Verbindung umfassend wenigstens zwei siliciumgebundene Wasserstoffatome pro auszuhärtendem Molekül über eine Hydrosilylierungsreaktion, und das Bilden des auf der ersten Schicht angeordneten Silikonelastomers; und
B. das Anordnen des zweiten Elastomers gegenüber dem Silikonelastomer und auf der kristallinen Photovoltaikzelle,
wobei die durch Hydrosilylierung aushärtbare Silikonzusammensetzung ein Organopolysiloxan mit durchschnittlich wenigstens zwei siliciumgebundenen Alkenylgruppen pro Molekül, ein Organohydrogensiloxan mit durchschnittlich wenigstens zwei siliciumgebundenen Wasserstoffatomen pro Molekül und einen Hydrosilylierungskatalysator umfasst und ein Molverhältnis von SiH:Alkenyl von weniger als ca. 1.2:1 aufweist, und
wobei das Photovoltaikzellenmodul eine Stoßfestigkeit von mehr als ca. 12 Newton (ca. 1.200 Gramm) aufweist.

2. Verfahren nach Anspruch 1, ferner umfassend den Schritt des Anordnens der durch Hydrosilylierung aushärtbaren Silikonzusammensetzung auf der ersten Schicht und/oder der kristallinen Photovoltaikzelle und wahlweise das Aushärten der durch Hydrosilylierung aushärtbaren Silikonzusammensetzung, um das ausgehärtete Silikongel zu bilden.

3. Verfahren nach Anspruch 1 oder 2, ferner umfassend den Schritt des Anordnens der siliciumhaltigen organischen Verbindung auf der ersten Schicht und/oder der kristallinen Photovoltaikzelle.

4. Verfahren nach einem der Schritte 1 bis 3, wobei das ausgehärtete Silikongel eine Penetrationstiefe von 1,1 bis 100 nm und einen Tack-Wert von weniger als -0,6 g.sec gemessen bei 25 °C hat.

5. Verfahren nach einem der Ansprüche 1, 2 oder 4, wobei die durch Hydrosilylierung aushärtbare Silikonzusammensetzung auf oder in direktem Kontakt mit der ersten Schicht und/oder der kristallinen Photovoltaikzelle angeordnet ist, wobei die kristalline Photovoltaikzelle das Silikonelastomer sandwichartig zwischen der ersten Schicht und der kristallinen Photovoltaikzelle einschließt und wobei das zweite Elastomer die kristalline Photovoltaikzelle sandwichartig zwischen dem Silikonelastomer und dem zweiten Elastomer einschließt.

6. Verfahren nach einem der Ansprüche 1, 2 oder 4, wobei die erste Schicht ein Superstrat ist, wobei die durch Hydrosilylierung aushärtbare Silikonzusammensetzung auf oder in direktem Kontakt mit der ersten Schicht und/oder der kristallinen Photovoltaikzelle angeordnet ist, wobei die kristalline Photovoltaikzelle das Silikonelastomer sandwichartig zwischen der ersten Schicht und der kristallinen Photovoltaikzelle einschließt, wobei das zweite Elastomer die kristalline Photovoltaikzelle sandwichartig zwischen dem Silikonelastomer und dem zweiten Elastomer einschließt, und wobei das Verfahren ferner den Schritt des Anordnens einer zweiten Schicht auf oder in direktem Kontakt mit dem zweiten Elastomer umfasst.

7. Verfahren nach einem der Ansprüche 1, 2 oder 4, wobei die erste Schicht ein Substrat ist, wobei die durch Hydrosilylierung aushärtbare Silikonzusammensetzung auf oder in direktem Kontakt mit der ersten Schicht und/oder der kristallinen Photovoltaikzelle angeordnet ist, wobei die kristalline Photovoltaikzelle das Silikonelastomer sandwichartig zwischen der ersten Schicht und der kristallinen Photovoltaikzelle einschließt, wobei das zweite Elastomer die kristalline Photovoltaikzelle sandwichartig zwischen dem Silikonelastomer und dem zweiten Elastomer einschließt, und wobei das Verfahren ferner den Schritt des Anordnens einer zweiten Schicht auf oder in direktem Kontakt mit dem zweiten Elastomer umfasst.

8. Verfahren nach einem der Ansprüche 1 bis 7, wobei die kristalline Photovoltaikzelle das Silikonelastomer sandwichartig zwischen der ersten Schicht und der kristallinen Photovoltaikzelle einschließt.

9. Verfahren nach einem der Ansprüche 1 bis 8, wobei das zweite Elastomer die kristalline Photovoltaikzelle sandwichartig zwischen dem Silikonelastomer und dem zweiten Elastomer einschließt und das zweite Elastomer wahlweise ein zweites Silikonelastomer ist.

10. Photovoltaikzellenmodul mit einer verbesserten Stoßfestigkeit, das Folgendes umfasst:
A. eine erste Schicht;
B. ein Silikonelastomer, das auf der ersten Schicht angeordnet ist und das Hydrosilylierungsreaktionsprodukt umfasst von:
(1) durch Hydrosilylierung aushärtbarer Silikonzusammensetzung und/oder einem ausgehärteten Silikongel davon, und
(2) einer siliciumhaltigen organischen Verbindung umfassend wenigstens zwei siliciumgebundene Wasserstoffatome pro Molekül;
C. eine auf dem Silikonelastomer angeordnete kristalline Photovoltaikzelle; und
D. ein gegenüber dem Silikonelastomer und auf der kristallinen Photovoltaikzelle angeordnetes zweites Elastomer,
wobei die durch Hydrosilylierung aushärtbare Silikonzusammensetzung (a) ein Organopolysiloxan mit durchschnittlich wenigstens zwei siliciumgebundenen Alkenylgruppen pro Molekül, (b) ein Organohydrogensiloxan mit durchschnittlich wenigstens zwei siliciumgebundenen Wasserstoffatomen pro Molekül und (c) einen Hydrosilylierungskatalysator umfasst und ein Molverhältnis von SiH:Alkenyl von weniger als ca. 1.2:1 aufweist, und
wobei das genannte Photovoltaikzellenmodul eine Stoßfestigkeit von mehr als ca. 12 Newton (ca. 1.200 Gramm) aufweist.

11. Modul nach Anspruch 10, wobei das ausgehärtete Silikongel eine Penetrationstiefe von 1,1 bis 100 nm und einen Tack-Wert von weniger als -0,6 g.sec gemessen bei 25 °C aufweist.

12. Modul nach Anspruch 10 oder 11, wobei das Silikonelastomer auf oder in direktem Kontakt mit der ersten Schicht und/oder der kristallinen Photovoltaikzelle angeordnet ist, wobei die kristalleine Photovoltaikzelle das Silikonelastomer sandwichartig zwischen der ersten Schicht und der kristallinen Photovoltaikzelle einschließt, und wobei das zweite Elastomer die kristalline Photovoltaikzelle sandwichartig zwischen dem Silikonelastomer und dem zweiten Elastomer einschließt.

13. Modul nach einem der Ansprüche 10 bis 12, wobei die siliciumhaltige organische Verbindung ein Organohydrogensilan ist.

14. Modul nach einem der Ansprüche 10 bis 12, wobei die siliciumhaltige organische Verbindung ein Organohydrogensiloxan ist.

15. Modul nach einem der Ansprüche 10 bis 12, das frei von einer Unterschicht und/oder frei von vorderseitigem Glas ist.

## Revendications

1. Procédé de formation d'un module de cellule photovoltaïque doté d'une résistance à l'impact améliorée et comprenant une première couche, un élastomère de silicone disposé sur la première couche, une cellule photovoltaïque cristalline disposée sur l'élastomère de silicone, et un deuxième élastomère disposé opposé à l'élastomère de silicone et sur la cellule photovoltaïque cristalline, ledit procédé comprenant les étapes consistant à :
A. mettre en contact une composition de silicone durcissable par hydrosilylation et/ou un gel de silicone durci de celui-ci avec un composé organosilicié comprenant au moins deux atomes d'hydrogène liés à du silicium par molécule pour durcir par l'intermédiaire d'une réaction d'hydrosilylation et former l'élastomère de silicone disposé sur la première couche ; et
B. disposer le deuxième élastomère opposé à l'élastomère de silicone et sur la cellule photovoltaïque cristalline,
dans lequel la composition de silicone durcissable par hydrosilylation comprend un organopolysiloxane possédant une moyenne d'au moins deux groupes alcényle liés à du silicium par molécule, un organohydrogénosiloxane possédant une moyenne d'au moins deux atomes d'hydrogène liés à du silicium par molécule, et un catalyseur d'hydrosilylation, et a un rapport molaire de SiH:alcényle inférieur à environ 1,2:1, et
dans lequel le module de cellule photovoltaïque a une résistance à l'impact supérieure à environ 12 Newtons (environ 1200 grammes).

2. Procédé selon la revendication 1, comprenant en outre l'étape consistant à disposer la composition de silicone durcissable par hydrosilylation sur la première couche et/ou la cellule photovoltaïque cristalline et à durcir facultativement la composition de silicone durcissable par hydrosilylation de façon à former le gel de silicone durci.

3. Procédé selon la revendication 1 ou 2, comprenant en outre l'étape consistant à disposer le composé organosilicié sur la première couche et/ou la cellule photovoltaïque cristalline.

4. Procédé selon l'une quelconque des revendications 1 à 3, dans lequel le gel de silicone durci a une profondeur de pénétration allant de 1,1 à 100 nm et une valeur d'adhésivité inférieure à -0,6 g.s mesurée à 25 °C.

5. Procédé selon l'une quelconque des revendications 1, 2 ou 4, dans lequel la composition de silicone durcissable par hydrosilylation est disposée sur, et en contact direct avec, la première couche et/ou la cellule photovoltaïque cristalline, dans lequel la cellule photovoltaïque cristalline intercale l'élastomère de silicone entre la première couche et la cellule photovoltaïque cristalline, et dans lequel le deuxième élastomère intercale la cellule photovoltaïque cristalline entre l'élastomère de silicone et le deuxième élastomère.

6. Procédé selon l'une quelconque des revendications 1, 2 ou 4, dans lequel la première couche est un superstrat, dans lequel la composition de silicone durcissable par hydrosilylation est disposée sur, et en contact direct avec, la première couche et/ou la cellule photovoltaïque cristalline, dans lequel la cellule photovoltaïque cristalline intercale l'élastomère de silicone entre la première couche et la cellule photovoltaïque cristalline, dans lequel le deuxième élastomère intercale la cellule photovoltaïque cristalline entre l'élastomère de silicone et le deuxième élastomère, et où le procédé comprend en outre l'étape consistant à disposer une deuxième couche sur, et en contact direct avec, le deuxième élastomère.

7. Procédé selon l'une quelconque des revendications 1, 2 ou 4, dans lequel la première couche est un substrat, dans lequel la composition de silicone durcissable par hydrosilylation est disposée sur, et en contact direct avec, la première couche et/ou la cellule photovoltaïque cristalline, dans lequel la cellule photovoltaïque cristalline intercale l'élastomère de silicone entre la première couche et la cellule photovoltaïque cristalline, dans lequel le deuxième élastomère intercale la cellule photovoltaïque cristalline entre l'élastomère de silicone et le deuxième élastomère, et où le procédé comprend en outre l'étape consistant à disposer une deuxième couche sur, et en contact direct avec, le deuxième élastomère.

8. Procédé selon l'une quelconque des revendications 1 à 7, dans lequel la cellule photovoltaïque cristalline intercale l'élastomère de silicone entre la première couche et la cellule photovoltaïque cristalline.

9. Procédé selon l'une quelconque des revendications 1 à 8 dans lequel le deuxième élastomère intercale la cellule photovoltaïque cristalline entre l'élastomère de silicone et le deuxième élastomère et le deuxième élastomère est facultativement un deuxième élastomère de silicone.

10. Module de cellule photovoltaïque possédant une résistance à l'impact améliorée et comprenant :
A. une première couche ;
B. un élastomère de silicone disposé sur ladite première couche et comprenant le produit de réaction d'hydrosilylation de ;
(1) une composition de silicone durcissable par hydrosilylation et/ou un gel de silicone durci de celui-ci, et
(2) un composé organosilicié comprenant au moins deux atomes d'hydrogène liés à du silicium par molécule ;
C. une cellule photovoltaïque cristalline disposée sur ledit élastomère de silicone ; et
D. un deuxième élastomère disposé opposé audit élastomère de silicone et sur ladite cellule photovoltaïque cristalline,
dans lequel ladite composition de silicone durcissable par hydrosilylation comprend (a) un organopolysiloxane possédant une moyenne d'au moins deux groupes alcényle liés à du silicium par molécule, (b) un organohydrogénosiloxane possédant une moyenne d'au moins deux atomes d'hydrogène liés à du silicium par molécule, et (c) un catalyseur d'hydrosilylation, et possédant un rapport molaire de SiH:alcényle inférieur à environ 1, et
dans lequel ledit module de cellule photovoltaïque a une résistance à l'impact supérieure à environ 12 Newtons (environ 1200 grammes).

11. Module selon la revendication 10, dans lequel ledit gel de silicone durci a une profondeur de pénétration allant de 1,1 à 100 nm et une valeur d'adhésivité inférieure à -0,6 g.s mesurée à 25 °C.

12. Module selon la revendication 10 ou 11, dans lequel ledit élastomère de silicone est disposé sur, et en contact direct avec, ladite première couche et ladite cellule photovoltaïque cristalline, dans lequel ladite cellule photovoltaïque cristalline intercale ledit élastomère de silicone entre ladite première couche et ladite cellule photovoltaïque cristalline, et dans lequel ledit deuxième élastomère intercale ladite cellule photovoltaïque cristalline entre ledit élastomère de silicone et ledit deuxième élastomère.

13. Module selon l'une quelconque des revendications 10 à 12, dans lequel ledit composé organosilicié est un organohydrogénosilane.

14. Module selon l'une quelconque des revendications 10 à 12, dans lequel ledit composé organosilicié est un organohydrogénosiloxane.

15. Module selon l'une quelconque des revendications 10 à 12, qui est exempt de feuille de fond et/ou exempt de verre avant.
